(19) Europäisches Patentamt
European Patent Office
Office européen des brevets

(11) **EP 4 576 570 A1**

(12) **EUROPEAN PATENT APPLICATION**
published in accordance with Art. 153(4) EPC

(43) Date of publication:
**25.06.2025 Bulletin 2025/26**

(21) Application number: **23854675.8**

(22) Date of filing: **22.03.2023**

(51) International Patent Classification (IPC):
**H03F 3/45** (2006.01)   **H03F 3/19** (2006.01)
**H03F 3/72** (2006.01)   **H03G 3/02** (2006.01)
**H03G 3/10** (2006.01)   **H03K 17/693** (2006.01)

(52) Cooperative Patent Classification (CPC):
**H03F 3/19; H03F 3/45; H03F 3/72; H03G 3/02;
H03G 3/10; H03G 3/20; H03G 3/30; H03K 17/693**

(86) International application number:
**PCT/JP2023/011193**

(87) International publication number:
**WO 2024/038635 (22.02.2024 Gazette 2024/08)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **19.08.2022 JP 2022130987**

(71) Applicant: **Fujikura Ltd.
Tokyo 135-8512 (JP)**

(72) Inventors:
• **KUBO Tatsuo
Sakura-shi, Chiba 285-8550 (JP)**
• **YAMAGUCHI Yo
Sakura-shi, Chiba 285-8550 (JP)**

(74) Representative: **Lavoix
Bayerstraße 83
80335 München (DE)**

(54) **AMPLIFIER WITH DIFFERENTIAL RF SWITCH FUNCTION**

(57) A differential amplifier with an RF switch function includes an input matching circuit, N (N is an integer of 2 or more) differential amplification circuits connected to the input matching circuit, and N output matching circuits connected to the N differential amplification circuits in a one-to-one manner. The N differential amplification circuits are connected in parallel. Only one of the N differential amplification circuits is driven.

FIG. 1

EP 4 576 570 A1

**Description**

TECHNICAL FIELD

The present invention relates to a differential amplifier with an RF switch function.

Priority is claimed on Japanese Patent Application No. 2022-130987, filed August 19, 2022, the content of which is incorporated herein by reference.

BACKGROUND ART

In the related art, as disclosed in Patent Document 1, an amplifier with a radio frequency (RF) switch function used in a wireless communication system is known. The amplifier with an RF switch function includes a common input port and a plurality of output ports that are independent of each other and are arranged in parallel. By setting an RF amplifier to be valid in ON state and setting an RF amplifier to be invalid in an OFF state, it is possible to select an output port to which a signal that is input through the input port is output.

Citation List

Patent Document

Patent Document 1: Japanese Unexamined Patent Application, First Publication No. 2007-336187

SUMMARY OF INVENTION

Technical Problem

In an amplifier with an RF switch function, a differential signal is often handled to reduce an influence of common mode noise and to implement a high gain.

In a case where a differential signal is handled in a circuit configuration disclosed in Patent Document 1, it is necessary to dispose elements such as a balun or the like used for conversion between a balanced circuit and an unbalanced circuit in an input portion of a circuit. Therefore, there is a problem in that a size of the amplifier with an RF switch function increases or noise characteristics deteriorate.

The present invention has been made in consideration of such circumstances, and an object of the present invention is to provide a differential amplifier with an RF switch function that can implement size reduction of a circuit and improvement of noise characteristics.

Solution to Problem

In order to solve the above-described problem, a differential amplifier with an RF switch function according to an aspect of the present invention includes an input matching circuit, N differential amplification circuits connected to the input matching circuit, and N output matching circuits connected to the N differential amplification circuits in a one-to-one manner. The N differential amplification circuits are connected in parallel, and only one of the N differential amplification circuits is driven. N is an integer of 2 or more.

With such a configuration, it is possible to output a differential signal without providing elements such as a balun or the like used for conversion between a balanced circuit and an unbalanced circuit, unlike the amplifier with a switch function in the related art. Therefore, it is possible to implement the size reduction of the circuit constituting the amplifier. Further, since it is possible to output the differential signal, it is possible to reduce the influence of common mode noise.

The differential amplifier with an RF switch function according to an aspect of the present invention may further include a sequence circuit connected to the N differential amplification circuits. In this case, each of the N differential amplification circuits may include a first transistor including a first driving terminal, a second transistor including a second driving terminal, and a bias circuit that outputs a drive signal to each of the first driving terminal and the second driving terminal. The sequence circuit may be configured to select any one differential amplification circuit from among the N differential amplification circuits and output a drive control signal to the bias circuit of the selected differential amplification circuit. The drive signal output from the bias circuit of the selected differential amplification circuit may be input to the first driving terminal of the first transistor and the second driving terminal of the second transistor of the selected differential amplification circuit.

With such a configuration, it is possible to drive the first transistor and the second transistor only in the one differential amplification circuit selected from among the N differential amplification circuits.

In the differential amplifier with an RF switch function according to an aspect of the present invention, the sequence circuit may be configured to output a power-down control signal to the bias circuit of the differential amplification circuit unselected from among the N differential amplification circuits. In this case, the bias circuit to which the power-down control signal is input may perform power-down control in the unselected differential amplification circuit.

With such a configuration, it is possible to perform the power-down control in the differential amplification circuit unselected from among the N differential amplification circuits.

In the differential amplifier with an RF switch function according to an aspect of the present invention, the sequence circuit may output, in a case where K differential amplification circuits among the N differential amplification circuits are sequentially and selectively driven one by one, drive control signals that are the same as each other to bias circuits of the K differential amplification circuits. K is an integer of 2 or more and N or less.

With this configuration, it is possible to control the K differential amplification circuits using the drive control signals that are the same as each other in a case where characteristics of the K differential amplification circuits among the N differential amplification circuits are the same as each other. As a result, it is possible to obtain the same gain (output) in each of the K differential amplification circuits.

In the differential amplifier with an RF switch function according to an aspect of the present invention, the sequence circuit may output, in a case where K differential amplification circuits among the N differential amplification circuits are sequentially and selectively driven one by one, drive control signals that are different from each other to bias circuits of the K differential amplification circuits. K is an integer of 2 or more and N or less.

With this configuration, it is possible to control the K differential amplification circuits using the drive control signals that are different from each other in a case where the characteristics of the K differential amplification circuits among the N differential amplification circuits are different from each other. In particular, it is possible to control the K differential amplification circuits such that the same output is obtained in each of the K differential amplification circuits even in a case where the characteristics of the K differential amplification circuits are different from each other.

In addition, it may be desired to vary the output of each of the differential amplification circuits even in a case where the characteristics of the K differential amplification circuits are the same as each other. In this case, the output can be varied by varying gains of the K differential amplification circuits using the drive control signals that are different from each other.

Advantageous Effects of Invention

According to the above-described aspect of the present invention, it is possible to provide a differential amplifier with an RF switch function that can implement size reduction of a circuit and improvement of noise characteristics.

BRIEF DESCRIPTION OF DRAWINGS

[FIG. 1] A block diagram showing a configuration of a differential amplifier with an RF switch function according to an embodiment of the present invention.

[FIG. 2] A circuit diagram showing the configuration of the differential amplifier with an RF switch function according to the embodiment of the present invention.

[FIG. 3] A circuit diagram showing a simple model of a source-grounded transistor of a differential amplification circuit in the differential amplifier with an RF switch function according to the embodiment of the present invention.

DESCRIPTION OF EMBODIMENTS

A differential amplifier 100 with an RF switch function according to an embodiment of the present invention will be described with reference to the drawings.

In the description of the embodiment, the same reference signs are assigned to configurations having the same or similar functions. Duplicate descriptions of such configurations may be omitted.

In addition, regarding names of terminals of components constituting the differential amplifier 100 with an RF switch function, the term "first end" can be replaced with the term "one end", and the term "second end" can be replaced with the term "other end". Here, the second end is a terminal located on a side opposite to the first end.

<Differential Amplifier with RF Switch Function>

The differential amplifier 100 with an RF switch function is, for example, a circuit used inside an integrated circuit (IC).

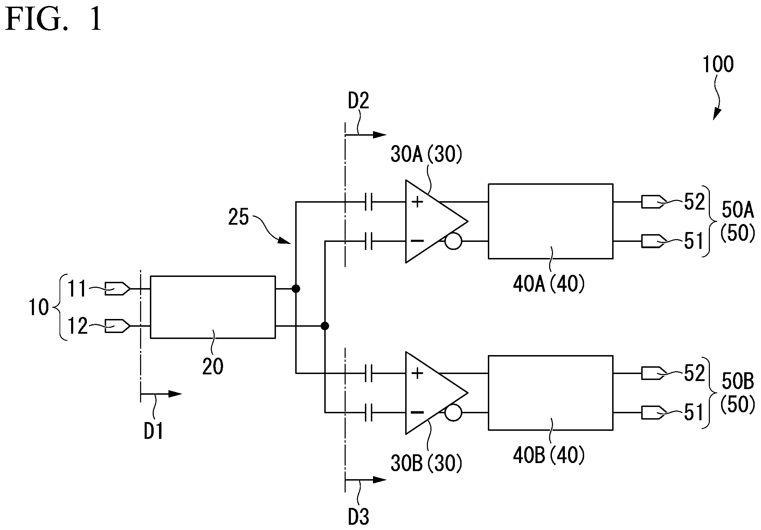

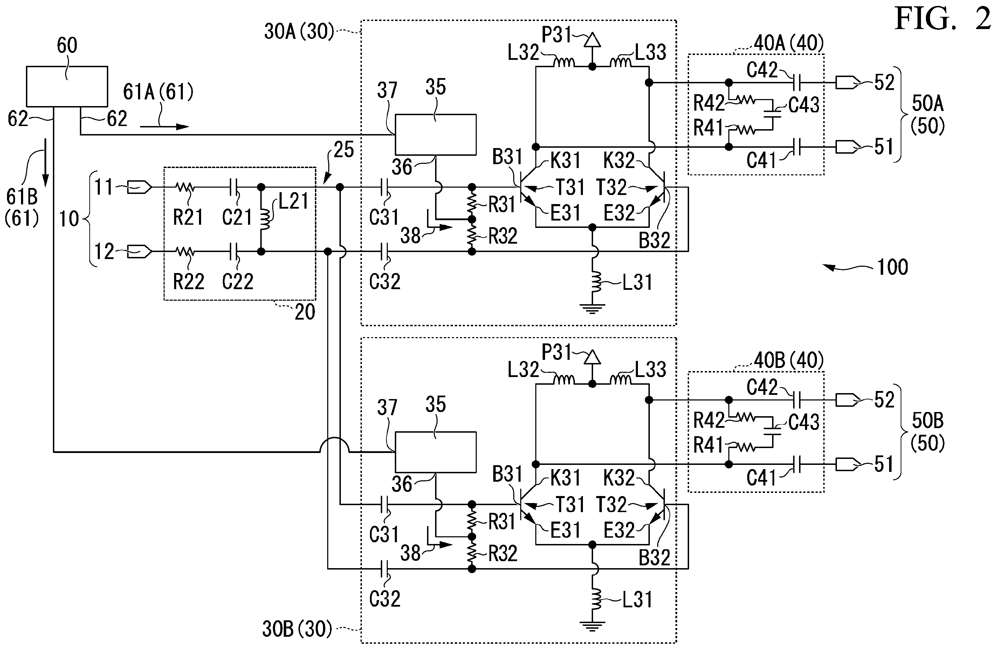

As shown in FIGS. 1 and 2, the differential amplifier 100 with an RF switch function includes a differential signal input port 10, an input matching circuit 20, two differential amplification circuits 30 (30A and 30B), two output matching circuits 40 (40A and 40B), two differential signal output ports 50 (50A and 50B), and a sequence circuit 60. In FIG. 1, the sequence circuit 60 is omitted.

In the present embodiment, the number of differential amplification circuits 30, the number of output matching circuits 40, and the number of differential signal output ports 50 are all two. The number of differential amplification circuits 30, the number of output matching circuits 40, and the number of differential signal output ports 50 may be three or more as long as the number is N (N is an integer of 2 two or more).

<Differential Signal Input Port>

The differential signal input port 10 is an example of an input port. The differential signal input port 10 is, for example, a port to which a signal having a frequency band of several tens of GHz, such as 20 GHz or 30 GHz, is input. The differential signal input port 10 is an input port to which each of two signals having phases different from each other is input.

Specifically, the differential signal input port 10 includes a first phase signal input port 11 and a second phase signal input port 12. The first phase signal input port 11 and the second phase signal input port 12 constitute a pair of signal input ports.

A phase of a differential input signal input to the first phase signal input port 11 is opposite to a phase of a differential input signal input to the second phase signal input port 12. In other words, a signal having a phase opposite to a phase of a signal input to the first phase signal input port 11 is input to the second phase signal input port 12.

In a case where the phase of the differential input signal input to the first phase signal input port 11 is an original phase, the phase of the differential input signal input to the second phase signal input port 12 is an opposite phase. On the contrary, in a case where the phase of the differential input signal input to the second phase signal input port 12 is the original phase, the phase of the differential input signal input to the first phase signal input port 11 is the opposite phase.

An input signal line (not shown) is connected to each of the first phase signal input port 11 and the second phase signal input port 12.

In the following description, two differential input signals having the phases opposite to each other may be simply referred to as "differential input signals".

<Input Matching Circuit>

The input matching circuit 20 is a circuit that matches input impedance. The input matching circuit 20 is disposed in a rear stage of the differential signal input port 10.

The input matching circuit 20 is connected to the differential signal input port 10 and is connected to the two differential amplification circuits 30A and 30B. In other words, the input matching circuit 20 is provided between the differential signal input port 10 and one differential amplification circuit 30A, and the input matching circuit 20 is provided between the differential signal input port 10 and the other differential amplification circuit 30B.

The number of input matching circuit 20 is one. The input matching circuit 20 is commonly connected to two differential amplification circuits 30A and 30B disposed in a rear stage of the input matching circuit 20.

A differential line 25 is disposed between the input matching circuit 20 and the two differential amplification circuits 30A and 30B. The differential line 25 branches off from the input matching circuit 20 according to the number of branches corresponding to the number of differential amplification circuits 30.

The input matching circuit 20 includes a first input resistor R21, a second input resistor R22, a first input capacitor C21, a second input capacitor C22, and an input matching inductor L21.

The first input resistor R21 is a resistor through which a signal in the original phase (or the opposite phase) flows.

The second input resistor R22 is a resistor through which a signal in the opposite phase (or the original phase) flows.

A first end of the first input resistor R21 is connected to the first phase signal input port 11.

A second end of the first input resistor R21 is connected to a first end of the first input capacitor C21.

A first end of the second input resistor R22 is connected to the second phase signal input port 12.

A second end of the second input resistor R22 is connected to a first end of the second input capacitor C22.

A second end of the first input capacitor C21 is connected to a first end of the input matching inductor L21, a first end of a first differential capacitor C31 of the first differential amplification circuit 30A, and a first end of a first differential capacitor C31 of the second differential amplification circuit 30B.

A second end of the second input capacitor C22 is connected to a second end of the input matching inductor L21, a first end of a second differential capacitor C32 of the first differential amplification circuit 30A, and a first end of a second differential capacitor C32 of the second differential amplification circuit 30B.

In a case where the number of the differential amplification circuits 30 is N, the second end of the first input capacitor C21 is connected to a first end of a first differential capacitor C31 of each of the first differential amplification circuit to N-th differential amplification circuit, and the second end of the second input capacitor C22 is connected to a first end of a second differential capacitor C32 of each of the first differential amplification circuit to the N-th differential amplification circuit.

<Differential Amplification Circuit>

The two differential amplification circuits 30A and 30B are connected to the input matching circuit 20, the two output matching circuits 40A and 40B, and the sequence circuit 60. Specifically, the two differential amplification circuits 30A and 30B are a first differential amplification circuit 30A and a second differential amplification circuit 30B.

The first differential amplification circuit 30A is provided between the input matching circuit 20 and one output matching circuit 40A. The second differential amplification circuit 30B is provided between the input matching circuit 20 and the other output matching circuit 40B.

Each of the first differential amplification circuit 30A and the second differential amplification circuit 30B has a gain setting function and a power down function.

In the following description, the first differential amplification circuit 30A and the second differential amplification circuit 30B may be simply referred to as differential amplification circuits 30A and 30B. In the present embodiment, since circuit configurations of the first differential amplification circuit 30A and the second differential amplification circuit 30B are the same, only the circuit configuration of the first differential amplification circuit 30A will be described, and the circuit configuration of the second differential amplification circuit 30B will not be described.

In other words, the description of components constituting the first differential amplification circuit 30A, that is, resistors, inductors, the capacitors, a first transistor, a second transistor, and a bias circuit is applied to the description of components constituting the second differential amplification circuit 30B.

The first differential amplification circuit 30A and the second differential amplification circuit 30B may have circuit configurations different from each other.

Each of the differential amplification circuits 30A and 30B includes the first differential capacitor C31, the second differential capacitor C32, a bias circuit 35, a first differential resistor R31, a second differential resistor R32, a first transistor T31, a second transistor T32, a first differential inductor L31, a second differential inductor L32, and a third differential inductor L33.

<First Differential Capacitor and Second Differential Capacitor>

The first end of the first differential capacitor C31 is connected to the second end of the first input capacitor C21 and the first end of the input matching inductor L21.

A second end of the first differential capacitor C31 is connected to a first end of the first differential resistor R31 and a first driving terminal B31 of the first transistor T31.

The first end of the second differential capacitor C32 is connected to the second end of the second input capacitor C22 and the second end of the input matching inductor L21.

A second end of the second differential capacitor C32 is connected to a second end of the second differential resistor R32 and a second driving terminal B32 of the second transistor T32.

<First Differential Resistor and Second Differential Resistor>

The first end of the first differential resistor R31 is connected to the second end of the first differential capacitor C31 and the first driving terminal B31.

A second end of the first differential resistor R31 is connected to an output end 36 of the bias circuit 35 and a first end of the second differential resistor R32.

The first end of the second differential resistor R32 is connected to a second end of the first differential resistor R31 and the output end 36 of the bias circuit 35.

A second end of the second differential resistor R32 is connected to the second end of the second differential capacitor C32 and the second driving terminal B32.

<First Transistor and Second Transistor>

The first transistor T31 includes the first driving terminal B31 to which a drive signal for controlling a driving state of the first transistor T31 is input.

The second transistor T32 includes the second driving terminal B32 to which a drive signal for controlling a driving state of the second transistor T32 is input.

Each of the first transistor T31 and the second transistor T32 is, for example, a bipolar transistor or a field effect transistor.

In a case where the transistor is a field effect transistor, the transistor has a source terminal, a drain terminal, and a gate terminal. In a case where the transistor is a bipolar transistor, the transistor has an emitter terminal, a collector terminal, and a base terminal.

Here, the source terminal or the emitter terminal can be rephrased as a "first terminal". The drain terminal or the collector terminal can be rephrased as a "second terminal". In addition, in a case where the drain terminal or the collector terminal is rephrased as the "first terminal", the source terminal or the emitter terminal can be rephrased as the "second terminal".

In addition, the gate terminal or the base terminal can be rephrased as a "third terminal". The gate terminal is a terminal to which a signal for switching an electrical connection state between the source terminal and the drain terminal to an opened state or a closed state is input. In addition, the base terminal is a terminal to which a signal for switching an electrical connection state between the emitter terminal and the collector terminal to an opened state or a closed state is input. The third terminal is the first driving terminal B31 of the first transistor T31 and the second driving terminal B32 of the second transistor T32.

In the following description, as an example, a case where each of the first transistor T31 and the second transistor T32 is an NPN type bipolar transistor will be described.

An emitter terminal E31 of the first transistor T31 is connected to a first end of the first differential inductor L31.

An emitter terminal E32 of the second transistor T32 is connected to the first end of the first differential inductor L31.

A collector terminal K31 of the first transistor T31 is connected to a first end of the second differential inductor L32, a first end of a first output resistor R41 of the output matching circuit 40, and a first end of a first output capacitor C41 of the output matching circuit 40.

A collector terminal K32 of the second transistor T32 is connected to a second end of the third differential inductor L33, a first end of a second output resistor R42 of the output matching circuit 40, and a first end of a second output capacitor C42 of the output matching circuit 40.

<First Differential Inductor, Second Differential Inductor, and Third Differential Inductor>

The first end of the first differential inductor L31 is connected to the emitter terminal E31 of the first transistor T31 and the emitter terminal E32 of the second transistor T32.

A second end of the first differential inductor L31 is connected to ground.

The first end of the second differential inductor L32 is connected to the collector terminal K31 of the first transistor T31, the first end of the first output resistor R41 of the output matching circuit 40, and the first end of the first output capacitor C41 of the output matching circuit 40.

A second end of the second differential inductor L32 is connected to a power supply P31 and a first end of the third differential inductor L33.

The first end of the third differential inductor L33 is connected to the power supply P31 and the second end of the second differential inductor L32.

The second end of the third differential inductor L33 is connected to the collector terminal K32 of the second transistor T32, the first end of the second output resistor R42 of the output matching circuit 40, and the first end of the second output capacitor C42 of the output matching circuit 40.

In FIG. 2, the power supply P31 is shown to be included in a part of the differential amplification circuit 30, but the power supply P31 need not be included in the differential amplification circuit 30.

<Bias Circuit>

The bias circuit 35 includes an input end 37 and the output end 36.

The input end 37 is connected to the sequence circuit 60.

The output end 36 is connected to the second end of the first differential resistor R31 and the first end of the second differential resistor R32.

The bias circuit 35 is configured to receive a control signal 61 output from the sequence circuit 60 to be described later. The bias circuit 35 is configured to output a direct current (DC) voltage 38 to each of the first driving terminal B31 of the first transistor T31 and the second driving terminal B32 of the second transistor T32 in response to the control signal 61 of the sequence circuit 60.

The DC voltage 38 is an example of a drive signal.

In other words, the bias circuit 35 includes a circuit configuration in which the DC voltage 38 in response to the control signal 61 output from the sequence circuit 60 is output.

The DC voltage 38 is applied to each of the first driving terminal B31 and the second driving terminal B32. A current corresponding to the DC voltage 38 flows through the first transistor T31 and the second transistor T32. A magnitude of the DC voltage 38 output from the bias circuit 35 is adjusted by the control signal 61 output from the sequence circuit 60 to be described later.

That is, the bias circuit 35 can adjust the DC voltage 38 output to the first driving terminal B31 and the second driving terminal B32 in response to the control signal 61 output from the sequence circuit 60. For example, the bias circuit 35 can increase the DC voltage 38 or decrease the DC voltage 38.

As a configuration of the bias circuit 35, a known circuit configuration is employed.

In other words, the bias circuit 35 is a circuit that receives a drive control signal 61A, which is one of control signals 61, or a power-down control signal 61B, which is one of the control signals 61.

The drive control signal 61A is a signal for adjusting the DC voltage 38 that drives the first transistor T31 and the second transistor T32 constituting the differential amplification circuit 30.

In the bias circuit 35, control of giving priority to the power-down control signal 61B over the drive control signal 61A is performed.

Specifically, in a state in which the bias circuit 35 receives the drive control signal 61A, the bias circuit 35 may receive the power-down control signal 61B. In this case, the bias circuit 35 stops the control based on the drive control signal 61A and performs the control based on the power-down control signal 61B. In the control based on the power-down control signal 61B, the bias circuit 35 outputs the DC voltage 38 having a low voltage value to the first transistor T31 and the second transistor T32. Accordingly, the bias circuit 35 can set the driving states of the first transistor T31 and the second transistor T32 in an OFF state.

The driving states of the first transistor T31 and the second transistor T32 are set in the OFF state, whereby power-down control is performed in the differential amplification circuit 30.

<Output Matching Circuit>

The two output matching circuits 40A and 40B are disposed in rear stages of the two differential amplification circuits 30A and 30B. The output matching circuits 40A and 40B are circuits that match output impedance.

The two output matching circuits 40A and 40B are connected to the two differential amplification circuits 30A and 30B in a one-to-one manner. Specifically, the two output matching circuits 40A and 40B are a first output matching circuit 40A and a second output matching circuit 40B. The first output matching circuit 40A is connected to the first differential amplification circuit 30A. The second output matching circuit 40B is connected to the second differential amplification circuit 30B.

In the following description, the first output matching circuit 40A and the second output matching circuit 40B may be simply referred to as the output matching circuits 40A and 40B. In addition, since circuit configurations of the first output matching circuit 40A and the second output matching circuit 40B are the same, only the circuit configuration of the first output matching circuit 40A will be described, and the circuit configuration of the second output matching circuit 40B will not be described.

In other words, the description of components constituting the first output matching circuit 40A, that is, the resistors and the capacitors, is applied to the description of components constituting the second output matching circuit 40B.

Each of the output matching circuits 40A and 40B has the first output resistor R41, the second output resistor R42, the first output capacitor C41, the second output capacitor C42, and a third output capacitor C43.

<First Output Resistor and Second Output Resistor>

The first end of the first output resistor R41 is connected to the collector terminal K31 of the first transistor T31, the first end of the second differential inductor L32, and the first end of the first output capacitor C41.

A second end of the first output resistor R41 is connected to a first end of the third output capacitor C43.

The first end of the second output resistor R42 is connected to the collector terminal K32 of the second transistor T32, the second end of the third differential inductor L33, and the first end of the second output capacitor C42 of the output matching circuit 40.

A second end of the second output resistor R42 is connected to a second end of the third output capacitor C43.

The first end of the second output capacitor C42 is connected to the collector terminal K32 of the second transistor T32, the second end of the third differential inductor L33, and the first end of the second output resistor R42.

A second end of the second output capacitor C42 is connected to a second phase signal output port 52 of the differential signal output port 50. The second phase signal output port 52 will be described later.

The first end of the first output capacitor C41 is connected to the collector terminal K31 of the first transistor T31, the first end of the second differential inductor L32, and the first end of the first output resistor R41.

A second end of the first output capacitor C41 is connected to a first phase signal output port 51 of the differential signal output port 50. The first phase signal output port 51 will be described later.

In a case where the number of differential amplification circuits 30 is N, the number of the output matching circuits 40 is also N. In other words, in a state where the above-described connection structure between the differential amplification circuit 30 and the output matching circuit 40 is applied, the first differential amplification circuit to the N-th differential amplification circuit and the first output matching circuit to the N-th output matching circuit are connected to each other in a one-to-one manner.

<Differential Signal Output Port>

Each of the two differential signal output ports 50A and 50B is an example of an output port.

The two differential signal output ports 50A and 50B are connected to the two output matching circuits 40A and 40B in a one-to-one manner. Specifically, the two differential signal output ports 50A and 50B are a first differential signal output port 50A and a second differential signal output port 50B. The first differential signal output port 50A is connected to the first output matching circuit 40A. The second differential signal output port 50B is connected to the second output matching circuit 40B.

Each of the first differential signal output port 50A and the second differential signal output port 50B has the first phase signal output port 51 and the second phase signal output port 52. The first phase signal output port 51 and the second phase signal output port 52 constitute a pair of signal output ports.

The first phase signal output port 51 outputs an amplified signal having the original phase (or the opposite phase) to an outside of the differential amplifier 100 with an RF switch function.

The second phase signal output port 52 outputs an amplified signal having the opposite phase (or the original phase) to the outside of the differential amplifier 100 with an RF switch function.

In the following description, the first differential signal output port 50A and the second differential signal output port 50B may be simply referred to as the differential signal output port 50.

In addition, since the first differential signal output port 50A and the second differential signal output port 50B are the same as each other, only the first differential signal output port 50A will be described, and the second differential signal output port 50B will not be described.

The differential signal output port 50 is a port from which a differential output signal is output. A phase of a differential output signal output from the first phase signal output port 51 is opposite to a phase of a differential output signal output from the second phase signal output port 52. In other words, a differential output signal having a phase opposite to a phase of the differential output signal output from the first phase signal output port 51 is output from the second phase signal output port 52. An output signal line (not shown) is connected to each of the first phase signal output port 51 and the second phase signal output port 52.

<Sequence Circuit>

The sequence circuit 60 has the same number of control lines 62 as the number of differential amplification circuits 30. The control line 62 is connected to the input end 37 of the bias circuit 35 constituting the differential amplification circuit 30. In the present embodiment, the number of control lines 62 is two, the same as the number of differential amplification circuits 30. In other words, in a case where the number of differential amplification circuits 30 is N, the number of control lines 62 is N.

Specifically, in the present embodiment, one of the two control lines 62 is connected to the input end 37 of the bias circuit 35 of the first differential amplification circuit 30A, and the sequence circuit 60 can supply the control signal 61 to the bias circuit 35. The other of the two control lines 62 is connected to the input end 37 of the bias circuit 35 of the second differential amplification circuit 30B, and the sequence circuit 60 can supply the control signal 61 to the bias circuit 35.

The control signal 61 consists of two signals of the drive control signal 61A and the power-down control signal 61B. In other words, the drive control signal 61A is one of the control signals 61. The power-down control signal 61B is one of the control signals 61. Here, signal types related to the drive control signal 61A and the power-down control signal 61B will be described. It is preferable to use an analog signal as the drive control signal 61A, which is the signal for adjusting the DC voltage 38. In addition, it is preferable to use a digital signal as the power-down control signal 61B. However, the signal types related to the drive control signal 61A and the power-down control signal 61B are not particularly limited. A digital signal may be used as the drive control signal 61A, or an analog signal may be used as the power-down control signal 61B. As the analog signal, for example, an analog current signal may be used.

The configurations of the sequence circuit 60 and the bias circuit 35 can be changed to be applied to the above-mentioned signal types.

<Drive Control Signal of Sequence Circuit>

In a case where K differential amplification circuits (K is an integer of 2 or more and N or less) among the N differential amplification circuits are sequentially and selectively driven one by one, the sequence circuit 60 can output drive control signals that are the same as each other to the bias circuits 35 of the K differential amplification circuits.

In a case where the K differential amplification circuits (K is an integer of 2 or more and N or less) among the N differential amplification circuits are sequentially and selectively driven one by one, the sequence circuit 60 can output drive control signals that are different from each other to the bias circuits 35 of the K differential amplification circuits.

Regarding the control through the sequence circuit 60 described above, in the present embodiment, two (N = 2) differential amplification circuits 30A and 30B are used, and two (K = 2) differential amplification circuits 30A and 30B are sequentially and selectively driven one by one. That is, in a case where two differential amplification circuits among the two differential amplification circuits are sequentially and selectively driven one by one, the sequence circuit 60 according to the present embodiment can output drive control signals that are different from each other to the bias circuits 35 of the two differential amplification circuits

A case where N is an integer of 3 or more and K is an integer of 2 or more will be described in a modification example.

The sequence circuit 60 according to the present embodiment is configured to supply the drive control signal 61A only to the bias circuit 35 of one differential amplification circuit of the first differential amplification circuit 30A and the second differential amplification circuit 30B, and to selectively drive only one differential amplification circuit. Further, the sequence circuit 60 can vary the drive control signal 61A depending on each of the first differential amplification circuit 30A and the second differential amplification circuit 30B.

For example, as a method of varying the drive control signal 61A, it is conceivable to change a magnitude of a voltage or a current. The drive control signal supplied to the bias circuit 35 of the first differential amplification circuit 30A may be referred to as a first drive control signal. The drive control signal supplied to the bias circuit 35 of the second differential amplification circuit 30B may be referred to as a second drive control signal.

In other words, with respect to the control of the two differential amplification circuits 30A and 30B, the sequence circuit 60 is configured to separately perform control of selecting only the first differential amplification circuit 30A, which is one of the two differential amplification circuits, and outputting the first drive control signal to the bias circuit 35 of the selected first differential amplification circuit 30A, and control of selecting only the second differential amplification circuit 30B, which is the other of the two differential amplification circuits 30A and 30B, and outputting the second drive control signal to the bias circuit 35 of the selected second differential amplification circuit 30B. In the present embodiment, the first drive control signal is different from the second drive control signal.

This point will be specifically described.

Characteristics of a plurality of differential amplification circuits constituting the differential amplifier 100 with an RF switch function are not necessarily the same as each other. For example, characteristics of the first differential amplification circuit 30A and characteristics of the second differential amplification circuit 30B may be different from each other. In the following description, this case will be referred to as a first case.

Further, even in a case where the characteristics of the first differential amplification circuit 30A and the characteristics of the second differential amplification circuit 30B are the same as each other, it may be desired to make the output of the first differential amplification circuit 30A different from the output of the second differential amplification circuit 30B. In the following description, this case will be referred to as a second case.

<First Case>

In a case where the characteristics of the first differential amplification circuit 30A and the characteristics of the second differential amplification circuit 30B are different from each other, the sequence circuit 60 can make the first drive control signal and the second drive control signal different from each other such that the output of the first differential amplification circuit 30A and the output of the second differential amplification circuit 30B are the same.

Next, a method of setting the first drive control signal and the second drive control signal in the first case will be described.

First, in consideration of the fact that the characteristics of the two differential amplification circuits are different from each other, the drive control signal 61A corresponding to the characteristics of each of the two differential amplification circuits is output. That is, in the case of the present embodiment, the first drive control signal and the second drive control signal supplied respectively to the bias circuit 35 of the first differential amplification circuit 30A and the bias circuit 35 of the second differential amplification circuit 30B are made different from each other according to the characteristics of each of the first differential amplification circuit 30A and the second differential amplification circuit 30B.

Thereafter, the bias circuit 35 supplies the DC voltage 38 (drive signal) corresponding to the drive control signal 61A to each of the two differential amplification circuits. That is, in the case of the present embodiment, the sequence circuit 60 supplies the first drive control signal to the bias circuit 35 of the first differential amplification circuit 30A and supplies the second drive control signal to the bias circuit 35 of the second differential amplification circuit 30B such that the output is the same in both the first differential amplification circuit 30A and the second differential amplification circuit 30B.

As described above, by making the first drive control signal and the second drive control signal different from each other, it is possible to obtain optimum characteristics in the first differential amplification circuit 30A and the second differential amplification circuit 30B.

<Second Case>

Even in a case where the characteristics of the first differential amplification circuit 30A and the characteristics of the second differential amplification circuit 30B are the same, in a case where it is desired to make the output of the first differential amplification circuit 30A and the output of the second differential amplification circuit 30B different from each other, the sequence circuit 60 can make the first drive control signal and the second drive control signal different from each other such that a gain of the first differential amplification circuit 30A and a gain of the second differential amplification circuit 30B are different from each other.

Next, a method of setting the first drive control signal and the second drive control signal in the second case will be described.

First, a gain type of each of the two differential amplification circuits controlled by the drive control signal 61A is set in advance. That is, in the case of the present embodiment, the gain type of the first differential amplification circuit 30A controlled by the first drive control signal and the gain type of the second differential amplification circuit 30B controlled by the second drive control signal are set in advance.

Specifically, the sequence circuit 60 supplies the drive control signal 61A to the bias circuit 35 of each of the two differential amplification circuits such that the set gain is obtained. Then, each bias circuit 35 supplies the DC voltage 38 (drive signal) to the corresponding differential amplification circuit.

That is, in the case of the present embodiment, the sequence circuit 60 supplies the first drive control signal to the bias circuit 35 of the first differential amplification circuit 30A and supplies the second drive control signal to the bias circuit 35 of the second differential amplification circuit 30B such that the set gain is obtained.

As described above, by making the first drive control signal and the second drive control signal different from each other, it is possible to obtain optimum characteristics in the output of the first differential amplification circuit 30A and the output of the second differential amplification circuit 30B.

In the description of the first case and the second case described above, the "gain type" is, for example, the type of a level of a gain. Specifically, the first drive control signal for obtaining a first gain may be supplied to the bias circuit 35 of one differential amplification circuit, and the second drive control signal for obtaining a second gain lower than the first gain may be supplied to the bias circuit 35 of the other differential amplification circuit.

In the case of the present embodiment, a gain controlled by the drive control signal 61A supplied to the bias circuit 35 of the first differential amplification circuit 30A may be set as the first gain, and a gain controlled by the drive control signal 61A supplied to the bias circuit 35 of the second differential amplification circuit 30B may be set as the second gain lower than the first gain. On the contrary, the gain controlled by the drive control signal 61A supplied to the bias circuit 35 of the second differential amplification circuit 30B may be set as the first gain, and the gain controlled by the drive control signal 61A supplied to the bias circuit 35 of the first differential amplification circuit 30A may be set as the second gain lower than the first gain.

<Drive Control of Transistor through Bias Circuit>

The sequence circuit 60 is configured to select any one differential amplification circuit 30 from among the N differential amplification circuits 30 and output the drive control signal 61 A to the bias circuit 35 of the selected differential amplification circuit 30. The sequence circuit 60 is configured to output the power-down control signal 61B to the bias circuit 35 of the differential amplification circuit 30 unselected from among the N differential amplification circuits 30.

The sequence circuit 60 selectively outputs the control signal 61 to the first differential amplification circuit 30A and the second differential amplification circuit 30B. As described above, the control signal 61 is the drive control signal 61A or the power-down control signal 61B. The control signal 61 selectively output from the sequence circuit 60 is input to the bias circuit 35 through the control line 62. In response to the control signal 61, the bias circuit 35 sets the states of the first transistor T31 and the second transistor T32 constituting the differential amplification circuit 30 in an ON state or the OFF state. The drive control is performed in the differential amplification circuit 30 such that the states of the first transistor T31 and the second transistor T32 are in the ON state. On the contrary, the power-down control is performed in the differential amplification circuit 30 such that the states of the first transistor T31 and the second transistor T32 are in the OFF state.

Here, the ON state means a state in which the first transistor T31 and the second transistor T32 are driven by the DC voltage 38 of the bias circuit 35.

In addition, the OFF state means a state in which the first transistor T31 and the second transistor T32 are not driven by the DC voltage 38 of the bias circuit 35.

In other words, the sequence circuit 60 can supply the drive control signal 61A to the input end 37 of the bias circuit 35 of the first differential amplification circuit 30A selected from among the plurality of differential amplification circuits, and can supply the power-down control signal 61B to the input end 37 of the bias circuit 35 of the second differential amplification circuit 30B unselected from among the plurality of differential amplification circuits.

In addition, the sequence circuit 60 can supply the power-down control signal 61B to the input end 37 of the bias circuit 35 of the first differential amplification circuit 30A unselected from among the plurality of differential amplification circuits, and can supply the drive control signal 61A to the input end 37 of the bias circuit 35 of the second differential amplification circuit 30B selected from among the plurality of differential amplification circuits.

In addition, the sequence circuit 60 can supply the power-down control signal 61B to the input end 37 of the bias circuit 35 of the first differential amplification circuit 30A unselected from among the plurality of differential amplification circuits, and can supply the power-down control signal 61B to the input end 37 of the bias circuit 35 of the second differential amplification circuit 30B unselected from among the plurality of differential amplification circuits.

The bias circuit 35 can drive the first transistor T31 and the second transistor T32 by the drive control signal 61A output from the sequence circuit 60.

Further, in the control using the drive control signal 61A, the magnitude of the DC voltage 38 output from the bias circuit 35 is adjusted, and the current flowing through the first transistor T31 and the second transistor T32 can be controlled by the magnitude of the DC voltage 38.

The bias circuit 35 may not drive the first transistor T31 and the second transistor T32 by the power-down control signal 61B output from the sequence circuit 60. In the control using the power-down control signal 61B, the bias circuit 35 sets the DC voltage 38 to a low DC voltage such that the first transistor T31 and the second transistor T32 are in the OFF state. As a result, the current flowing through the first transistor T31 and the second transistor T32 indicates a sufficiently low current value. Here, the sufficiently low current value is substantially 0 A.

As long as the type of the control signal 61 and the circuit configuration of the bias circuit 35 can be associated with each other, the type of the control signal 61 is not particularly limited. As the control signal 61, for example, a digital signal or an analog signal (DC current or the like) can be generally used.

The sequence circuit 60 is configured to output the control signal 61 to the bias circuit 35 such that only one differential amplification circuit of the first differential amplification circuit 30A and the second differential amplification circuit 30B is driven and the other differential amplification circuit is not driven.

In other words, the sequence circuit 60 is configured to output the control signal 61 to the bias circuit 35 such that only one differential amplification circuit 30 among the N differential amplification circuits 30 is driven and (N-1) differential amplification circuits 30 are not driven in a case where the number of differential amplification circuits 30 is N.

<Operation of Differential Amplifier with RF Switch Function>

Next, an operation of the differential amplifier 100 with an RF switch function will be described.

For example, the differential signal of 20 GHz or 30 GHz is input to the differential signal input port 10. Specifically, one signal of two differential input signals having the phases opposite to each other is input to the first phase signal input port 11, and the other signal is input to the second phase signal input port 12.

After that, the differential input signal is input from the differential signal input port 10 to the input matching circuit 20. The differential input signal passes through the first input resistor R21, the second input resistor R22, the first input capacitor C21, the second input capacitor C22, and the input matching inductor L21, and is output from the input matching circuit 20. The differential input signal output from the input matching circuit 20 is input to both the first differential amplification circuit 30A and the second differential amplification circuit 30B.

In each of the first differential amplification circuit 30A and the second differential amplification circuit 30B, the control of the bias circuit 35 is performed in response to the control signal 61 of the sequence circuit 60. In other words, in each of the first differential amplification circuit 30A and the second differential amplification circuit 30B, the bias circuit 35 performs the control related to whether to drive the first transistor T31 and the second transistor T32.

<Control through Sequence Circuit>

Next, the following three kinds of control will be described as control through the sequence circuit 60.

· Control 1: The drive control is performed in the first differential amplification circuit 30A, and the power-down control is performed in the second differential amplification circuit 30B.
· Control 2: The power-down control is performed in the first differential amplification circuit 30A, and the drive control is performed in the second differential amplification circuit 30B.

· Control 3: The power-down control is performed in both the first differential amplification circuit 30A and the second differential amplification circuit 30B.

<Control 1: First Differential Amplification Circuit: Drive Control/Second Differential Amplification Circuit: Power-Down Control>

The sequence circuit 60 outputs the drive control signal 61A to the bias circuit 35 of the first differential amplification circuit 30A via the control line 62. **In** a case where the bias circuit 35 of the first differential amplification circuit 30A receives the drive control signal 61A, the bias circuit 35 outputs the DC voltage 38 to the first driving terminal B31 of the first transistor T31 via the first differential resistor R31.

Similarly, the bias circuit 35 of the first differential amplification circuit 30A outputs the DC voltage 38 to the second driving terminal B32 of the second transistor T32 via the second differential resistor R32.

The gain controlled by the drive control signal 61A supplied to the bias circuit 35 of the first differential amplification circuit 30A in the control 1 may be higher than the gain controlled by the drive control signal 61A supplied to the bias circuit 35 of the second differential amplification circuit 30B in the control 2 to be described later. **In** other words, the gain controlled by the drive control signal 61A supplied to the first differential amplification circuit 30A in the control 1 is the first gain, and the gain controlled by the drive control signal 61A supplied to the second differential amplification circuit 30B in the control 2 is the second gain lower than the first gain.

On the contrary, the gain controlled by the drive control signal 61A supplied to the bias circuit 35 of the second differential amplification circuit 30B in the control 2 to be described later may be higher than the gain controlled by the drive control signal 61A supplied to the bias circuit 35 of the first differential amplification circuit 30A in the control 1. In other words, the gain controlled by the drive control signal 61A supplied to the second differential amplification circuit 30B in the control 2 is the first gain, and the gain controlled by the drive control signal 61A supplied to the first differential amplification circuit 30A in the control 1 is the second gain lower than the first gain.

Here, among the differential input signals output from the input matching circuit 20, the differential input signal passing through the first differential capacitor C31 is input to the first driving terminal B31 together with the DC voltage 38.

Among the differential input signals output from the input matching circuit 20, the differential input signal passing through the second differential capacitor C32 is input to the second driving terminal B32 together with the DC voltage 38. As a result, the first transistor T31 and the second transistor T32 are driven (ON state).

In a case where the first transistor T31 and the second transistor T32 are in the ON state, the differential input signal is amplified. That is, the voltage of the power supply P31 corresponding to the DC voltage 38 is output from the first differential amplification circuit 30A as a differential amplification signal. Specifically, the voltage of the power supply P31 is output from the collector terminal K31 of the first transistor T31 and the collector terminal K32 of the second transistor T32 via the first differential inductor L31, the second differential inductor L32, and the third differential inductor L33. The differential amplification signal output from the first differential amplification circuit 30A is input to the first output matching circuit 40A.

The differential amplification signal passes through the first output resistor R41, the second output resistor R42, the first output capacitor C41, the second output capacitor C42, and the third output capacitor C43, and is output from the first output matching circuit 40A. The signal output from the first output matching circuit 40A is the differential output signal.

The differential output signal is output to the outside of the differential amplifier 100 with an RF switch function via the first differential signal output port 50A.

Specifically, one signal of the two differential output signals having the phases opposite to each other is output to the outside of the differential amplifier 100 with an RF switch function via the first phase signal output port 51, and the other signal is output to the outside of the differential amplifier 100 with an RF switch function via the second phase signal output port 52.

In the above-described control 1, the sequence circuit 60 selectively drives the first differential amplification circuit 30A (drive control). On the other hand, the sequence circuit 60 outputs the power-down control signal 61B to the bias circuit 35 of the second differential amplification circuit 30B. Accordingly, the sequence circuit 60 does not selectively drive the second differential amplification circuit 30B (power-down control).

<Input Impedance Matching in Control 1>

Input impedance matching will be described with reference to FIG. 1.

In a case where the drive control is performed in the first differential amplification circuit 30A and the power-down control is performed in the second differential amplification circuit 30B, input impedance Zin can be represented as Formula 1 below.

[Formula 1]

$$Z_{in} = Z_1 + \left( Z_{2\_on} // Z_{2\_off} \right) \qquad \cdots \text{ Formula 1}$$

Zin is impedance of the input matching circuit 20 as viewed from a position indicated by a reference sign D1 shown in FIG. 1. Z2_on is impedance of the first differential amplification circuit 30A as viewed from a position indicated by a reference sign D2 shown in FIG. 1. In other words, the reference sign Z2_on is impedance of the differential amplification circuit in which the drive control is performed. Z2_off is impedance of the second differential amplification circuit 30B as viewed from a position indicated by a reference sign D3 shown in FIG. 1. In other words, the reference sign Z2_off is impedance of the differential amplification circuit in which the power-down control is performed.

On the right-hand side of Formula 1, (Z2_on//Z2_off) indicates parallel resistance of Z2_on and Z2_off. Z2_on is input impedance of the first differential amplification circuit 30A in a case where the drive control is performed in the first differential amplification circuit 30A. Z2_off is input impedance of the second differential amplification circuit 30B in a case where the power-down control is performed in the second differential amplification circuit 30B. A value of Z2_on and a value of Z2_off are different from each other.

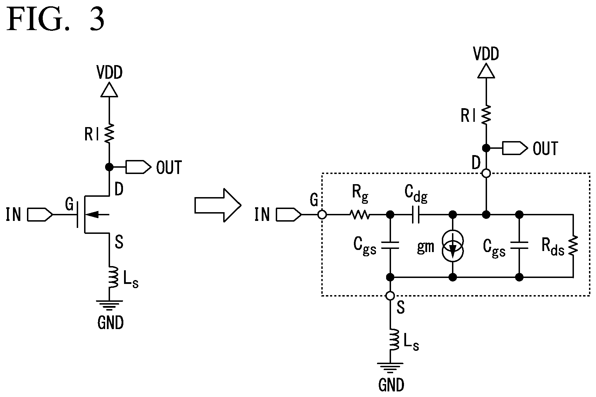

FIG. 3 is a circuit diagram showing a simple model of a source-grounded transistor in a differential amplification circuit constituting the differential amplifier 100 with an RF switch function. In FIG. 3, reference signs S, D, and G correspond to the emitter terminal, the collector terminal, and the base terminal of the bipolar transistor.

In addition, the reference signs S, D, and G are the source terminal, the drain terminal, and the gate terminal of the field effect transistor.

In consideration of the simple model shown in FIG. 3, the above-described Z2_on can be represented as Formula 2 below.

[Formula 2]

$$Z_{2-on} = \left[ R_g + \frac{L_s gm}{C_{gs}} \right] - j \left[ \frac{1}{\omega C_{gs}} - \omega \left( 1 + R_g L_s gm \right) L_s \right]$$

$$\cdots \text{ Formula 2}$$

In consideration of the simple model shown in FIG. 3, the above-described Z2_off can be represented as Formula 3 below.

[Formula 3]

$$Z_{2-off} = \left[ R_g \right] - j \left[ \frac{1}{\omega C_{gs}} - \omega L_s \right] \qquad \cdots \text{ Formula 3}$$

In a case where the power-down control is performed in the second differential amplification circuit 30B, no current flows through the transistor. Therefore, in Formula 3, a transconductance (gm) shown in Formula 2 is 0.

Therefore, the value of Z2_on and the value of Z2_off are different from each other.

<Control 2: First Differential Amplification Circuit: Power-Down Control/Second Differential Amplification Circuit: Drive Control>

In the following description, the same description as that of the above-described control 1 will be omitted.

The sequence circuit 60 outputs the drive control signal 61A to the bias circuit 35 of the second differential amplification circuit 30B via the control line 62. In a case where the bias circuit 35 of the second differential amplification circuit 30B receives the drive control signal 61A, the bias circuit 35 outputs the DC voltage 38 to the first driving terminal B31 of the first transistor T31 via the first differential resistor R31.

Similarly, the bias circuit 35 of the second differential amplification circuit 30B outputs the DC voltage 38 to the second driving terminal B32 of the second transistor T32 via the second differential resistor R32. As a result, the first transistor T31 and the second transistor T32 are driven (ON state).

In a case where the first transistor T31 and the second transistor T32 are in the ON state, the differential input signal is amplified. That is, the differential input signal input from the differential signal input port 10 is output from the second differential amplification circuit 30B as the differential amplification signal. The differential amplification signal output from the second differential amplification circuit 30B is input to the second output matching circuit 40B.

The differential amplification signal passes through the first output resistor R41, the second output resistor R42, the first output capacitor C41, the second output capacitor C42, and the third output capacitor C43, and is output from the second output matching circuit 40B. The signal output from the second output matching circuit 40B is the differential output signal.

The differential output signal is output to the outside of the differential amplifier 100 with an RF switch function via the second differential signal output port 50B.

Specifically, one signal of the two differential output signals having the phases opposite to each other is output to the outside of the differential amplifier 100 with an RF switch function via the first phase signal output port 51, and the other signal is output to the outside of the differential amplifier 100 with an RF switch function via the second phase signal output port 52.

In the above-described control 2, the sequence circuit 60 selectively drives the second differential amplification circuit 30B (drive control). On the other hand, the sequence circuit 60 outputs the power-down control signal 61B to the bias circuit 35 of the first differential amplification circuit 30A. Accordingly, the sequence circuit 60 does not selectively drive the first differential amplification circuit 30A (power-down control).

In FIG. 2, a state of the control 1, that is, a state where the drive control signal 61A is output to the bias circuit 35 of the first differential amplification circuit 30A and the power-down control signal 61B is output to the bias circuit 35 of the second differential amplification circuit 30B is shown. In a case of the control 2, the drive control signal 61A shown in FIG. 2 is output to the bias circuit 35 of the second differential amplification circuit 30B, and the power-down control signal 61B is output to the bias circuit 35 of the first differential amplification circuit 30A.

In addition, in a case where the input impedance matching in the control 2 is described, the above-described description of the control 1 is applied to the description of the control 2 by replacing an interpretation of Z2_on described in the description of the control 1 with the impedance of the second differential amplification circuit 30B in which the drive control is performed and by replacing an interpretation of Z2_off with the impedance of the first differential amplification circuit 30A in which the power-down control is performed.

<Control 3: First Differential Amplification Circuit: OFF State/Second Differential Amplification Circuit: OFF State>

In the control 3, the sequence circuit 60 does not drive both the first differential amplification circuit 30A and the second differential amplification circuit 30B (power-down control).

That is, in the control 3, the power-down control signal 61B is output to the bias circuits 35 of both the first differential amplification circuit 30A and the second differential amplification circuit 30B.

The control 3 as above is control selected in an overall down mode of the differential amplifier 100 with an RF switch function.

<Effect>

With the differential amplifier 100 with an RF switch function according to the above-described embodiment, it is possible to output a differential signal without providing elements such as a balun or the like used for conversion between a balanced circuit and an unbalanced circuit, unlike the amplifier with a switch function in the related art. Therefore, it is possible to implement the size reduction of the circuit constituting the differential amplifier 100 with an RF switch function.

Further, since it is possible to output the differential signal, it is possible to reduce the influence of common mode noise.

In the above-described control 1 and control 2, a method of performing the drive control in one differential amplification circuit and performing the power-down control in the other differential amplification circuit in a case where the number of differential amplification circuits is two has been described.

In a case where the number of differential amplification circuits is N, the same effect as the above-described effect can be obtained by performing the drive control in one differential amplification circuit and performing the power-down control in (N-1) differential amplification circuits.

<Modification Example 1>

In the above-described embodiment, a case where the two (N = 2) differential amplification circuits 30A and 30B are used, and the two (K = 2) differential amplification circuits 30A and 30B are sequentially and selectively driven one by one, and the sequence circuit 60 outputs the drive control signals that are different from each other to the bias circuits 35 of the two differential amplification circuits has been described. That is, in the above-described embodiment, a case where the first drive control signal and the second drive control signal are different from each other has been described.

In the present modification example, the first drive control signal and the second drive control signal may be the same. For example, in a case where the characteristics of the first differential amplification circuit 30A and the characteristics of the second differential amplification circuit 30B are the same, the first drive control signal may be set to be the same as the second drive control signal. In this case, the sequence circuit 60 can drive the first differential amplification circuit 30A by supplying the first drive control signal to the bias circuit 35 of the first differential amplification circuit 30A. Further, the sequence circuit 60 can drive the second differential amplification circuit 30B by supplying the second drive control signal, which is the same as the first drive control signal, to the bias circuit 35 of the second differential amplification circuit 30B.

<Modification Example 2>

In the above-described embodiment, two (N = 2) differential amplification circuits are used, and two (K = 2) differential amplification circuits are sequentially and selectively driven one by one.

Here, N need only be an integer of 2 or more, and a value of N is not limited to 2. In addition, K need only be an integer of 2 or more and N or less, and a value of K is not limited to 2.

Here, a case where N is 10 and K is 5 will be described.

That is, the differential amplifier 100 with an RF switch function according to the present modification example has the following ten differential amplification circuits.

· First differential amplification circuit 30A

· Second differential amplification circuit 30B

· Third differential amplification circuit 30C

· Fourth differential amplification circuit 30D

· Fifth differential amplification circuit 30E

· Sixth differential amplification circuit 30F

· Seventh differential amplification circuit 30G

· Eighth differential amplification circuit 30H

· Ninth differential amplification circuit 301

· Tenth differential amplification circuit 30J

Five differential amplification circuits among ten differential amplification circuits, for example, the third differential amplification circuit 30C, the fourth differential amplification circuit 30D, the fifth differential amplification circuit 30E, the sixth differential amplification circuit 30F, and the seventh differential amplification circuit 30G are differential amplification circuits that are sequentially and selectively driven one by one by the sequence circuit 60.

The sequence circuit 60 outputs drive control signals to the bias circuits 35 of the five differential amplification circuits. The drive control signals supplied to the bias circuits 35 of the five differential amplification circuits are the same as each other.

According to the present modification example, in a case where characteristics of five differential amplification circuits among the ten differential amplification circuits are the same as each other, the five differential amplification circuits can be controlled using the same drive control signals. Accordingly, the same gain can be obtained in each of the five differential amplification circuits.

<Modification Example 3>

Next, Modification Example 3 will be described.

In Modification Example 3, the same members as those in Modification Example 2 described above are denoted by the same reference signs, and the description thereof will be omitted or simplified.

In Modification Example 3, three differential amplification circuits among the ten differential amplification circuits, for example, the seventh differential amplification circuit 30G, the eighth differential amplification circuit 30H, and the ninth differential amplification circuit 30I are differential amplification circuits that are sequentially and selectively driven one by one by the sequence circuit 60.

The sequence circuit 60 outputs drive control signals to the bias circuits 35 of the three differential amplification circuits. The drive control signals supplied to the bias circuits 35 of the three differential amplification circuits are different from each other.

According to the present modification example, it is possible to control the three differential amplification circuits using the drive control signals that are different from each other in a case where characteristics of the three differential amplification circuits among the ten differential amplification circuits are different from each other. In particular, it is possible to control gains of the three differential amplification circuits such that the same output is obtained in each of the three differential amplification circuits even in a case where the characteristics of the three differential amplification circuits are different from each other.

In addition, even in a case where the characteristics of the three differential amplification circuits are the same, it may be desired to vary the output of the three differential amplification circuits. In this case as well, the three differential amplification circuits can be controlled using the drive control signals that are different from each other.

Although the preferred embodiments of the present invention have been described above, it should be understood that these are exemplary descriptions of the present invention and should not be considered as limiting descriptions. Additions, omissions, substitutions, and other modifications can be made without departing from the scope of the present invention. Accordingly, the invention is not to be considered as being limited by the foregoing description, and is only limited by the scope of the claims.

REFERENCE SIGNS LIST

10 Differential signal input port (input port), 11 First phase signal input port, 12 Second phase signal input port, 20 Input matching circuit, 25 Differential line, 30 Differential amplification circuit, 30A First differential amplification circuit (differential amplification circuit), 30B Second differential amplification circuit (differential amplification circuit), 30C Third differential amplification circuit (differential amplification circuit), 30D Fourth differential amplification circuit (differential amplification circuit), 30E Fifth differential amplification circuit (differential amplification circuit), 30F Sixth differential amplification circuit (differential amplification circuit), 30G Seventh differential amplification circuit (differential amplification circuit), 30H Eighth differential amplification circuit (differential amplification circuit), 30I Ninth differential amplification circuit (differential amplification circuit), 30J Tenth differential amplification circuit (differential amplification circuit), 35 Bias circuit, 36 Output end, 37 Input end, 38 DC voltage (drive signal), 40 Output matching circuit, 40A First output matching circuit (output matching circuit), 40B Second output matching circuit (output matching circuit), 50 Differential signal output port (output port), 50A First differential signal output port (differential signal output port), 50B Second differential signal output port (differential signal output port), 51 First phase signal output port, 52 Second phase signal output port, 60 Sequence circuit, 61 Control signal, 61A Drive control signal (control signal), 61B Power-down control signal (control signal), 62 Control line, 100 Differential amplifier with RF switch function, B31 First driving terminal, B32 Second driving terminal, C21 First input capacitor, C22 Second input capacitor, C31 First differential capacitor, C32 Second differential capacitor, C41 First output capacitor, C42 Second output capacitor, C43 Third output capacitor, E31, E32 Emitter terminal, K31, K32 Collector terminal, L21 Input matching inductor, L31 First differential inductor, L32 Second differential inductor, L33 Third differential inductor, P31 Power supply, R21 First input resistor, R22 Second input resistor, R31 First differential resistor, R32 Second differential resistor, R41 First output resistor, R42 Second output resistor, T31 First transistor, T32 Second transistor

**Claims**

1. A differential amplifier with an RF switch function, the differential amplifier comprising:

   an input matching circuit;
   N differential amplification circuits connected to the input matching circuit; and
   N output matching circuits connected to the N differential amplification circuits in a one-to-one manner,
   wherein the N differential amplification circuits are connected in parallel,
   only one of the N differential amplification circuits is driven, and
   N is an integer of 2 or more.

2. The differential amplifier with an RF switch function according to Claim 1, further comprising:

a sequence circuit connected to the N differential amplification circuits,

wherein each of the N differential amplification circuits includes a first transistor including a first driving terminal, a second transistor including a second driving terminal, and a bias circuit that outputs a drive signal to each of the first driving terminal and the second driving terminal,

the sequence circuit is configured to select any one differential amplification circuit from among the N differential amplification circuits and output a drive control signal to the bias circuit of the selected differential amplification circuit, and

the drive signal output from the bias circuit of the selected differential amplification circuit is configured to be input to the first driving terminal of the first transistor and the second driving terminal of the second transistor of the selected differential amplification circuit.

3. The differential amplifier with an RF switch function according to Claim 2,

wherein the sequence circuit is configured to output a power-down control signal to the bias circuit of the differential amplification circuit unselected from among the N differential amplification circuits, and

the bias circuit to which the power-down control signal is input is configured to perform power-down control in the unselected differential amplification circuit.

4. The differential amplifier with an RF switch function according to Claim 2,

wherein the sequence circuit is configured to output, in a case where K differential amplification circuits among the N differential amplification circuits are sequentially and selectively driven one by one, drive control signals that are the same as each other to bias circuits of the K differential amplification circuits, and

K is an integer of 2 or more and N or less.

5. The differential amplifier with an RF switch function according to Claim 2,

wherein the sequence circuit is configured to output, in a case where K differential amplification circuits among the N differential amplification circuits are sequentially and selectively driven one by one, drive control signals that are different from each other to bias circuits of the K differential amplification circuits, and

K is an integer of 2 or more and N or less.

FIG. 1

EP 4 576 570 A1

FIG. 2

EP 4 576 570 A1

FIG. 3

## INTERNATIONAL SEARCH REPORT

International application No.

**PCT/JP2023/011193**

### A.    CLASSIFICATION OF SUBJECT MATTER

*H03F 3/45*(2006.01)i; *H03F 3/19*(2006.01)i; *H03F 3/72*(2006.01)i; *H03G 3/02*(2006.01)i; *H03G 3/10*(2006.01)i; *H03K 17/693*(2006.01)i

FI:    H03F3/45; H03G3/02 B; H03G3/10 A; H03F3/19; H03F3/72; H03K17/693 A

According to International Patent Classification (IPC) or to both national classification and IPC

### B.    FIELDS SEARCHED

Minimum documentation searched (classification system followed by classification symbols)

H03F3/45; H03F3/19; H03F3/72; H03G3/02; H03G3/10; H03K17/693

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C.    DOCUMENTS CONSIDERED TO BE RELEVANT

| Category* | Citation of document, with indication, where appropriate, of the relevant passages | Relevant to claim No. |
|---|---|---|
| Y | JP 2007-336187 A (NIPPON TELEGRAPH AND TELEPHONE CORP.) 27 December 2007 (2007-12-27)<br>paragraphs [0030], [0035]-[0038], fig. 5-7 | 1 |
| A | | 2-5 |
| Y | WO 03/084059 A1 (THINE ELECTRONICS INC.) 09 October 2003 (2003-10-09)<br>specification, p. 5, line 17 to p. 6, line 10, fig. 1 | 1 |
| A | | 2-5 |
| Y | JP 11-177357 A (FUJITSU LTD.) 02 July 1999 (1999-07-02)<br>paragraphs [0017]-[0020], [0043]-[0057], fig. 1, 3, 4 | 1 |
| A | | 2-5 |
| A | JP 2007-158422 A (SONY CORP.) 21 June 2007 (2007-06-21)<br>paragraphs [0022]-[0030], fig. 1-3 | 1-5 |

☐ Further documents are listed in the continuation of Box C.        ☑ See patent family annex.

| | | |
|---|---|---|
| * | Special categories of cited documents: | |
| "A" | document defining the general state of the art which is not considered to be of particular relevance | "T"    later document published after the international filing date or priority date and not in conflict with the application but cited to understand the principle or theory underlying the invention |
| "E" | earlier application or patent but published on or after the international filing date | "X"    document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&"    document member of the same patent family |

| Date of the actual completion of the international search | Date of mailing of the international search report |
|---|---|
| **24 May 2023** | **06 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2023/011193**

| Patent document cited in search report | | | Publication date (day/month/year) | Patent family member(s) | Publication date (day/month/year) |
|---|---|---|---|---|---|
| JP | 2007-336187 | A | 27 December 2007 | (Family: none) | |
| WO | 03/084059 | A1 | 09 October 2003 | (Family: none) | |
| JP | 11-177357 | A | 02 July 1999 | (Family: none) | |
| JP | 2007-158422 | A | 21 June 2007 | (Family: none) | |

Form PCT/ISA/210 (patent family annex) (January 2015)

**REFERENCES CITED IN THE DESCRIPTION**

**Patent documents cited in the description**

- JP 2022130987 A

- JP 2007336187 A